(19) Europäisches Patentamt

European Patent Office

Office européen des brevets

(11) **EP 0 885 482 B1**

(12) **EUROPÄISCHE PATENTSCHRIFT**

(45) Veröffentlichungstag und Bekanntmachung des Hinweises auf die Patenterteilung:
**04.08.1999 Patentblatt 1999/31**

(21) Anmeldenummer: **97929198.6**

(22) Anmeldetag: **17.06.1997**

(51) Int Cl.⁶: **H03F 1/32**

(86) Internationale Anmeldenummer:
**PCT/EP97/03148**

(87) Internationale Veröffentlichungsnummer:
**WO 97/49174 (24.12.1997 Gazette 1997/55)**

(54) **VORVERZERRUNG FÜR EINE NICHTLINEARE ÜBERTRAGUNGSSTRECKE IM HOCHFREQUENZBEREICH**

PRE-DISTORTION FOR A NON-LINEAR TRANSMISSION PATH IN THE HIGH FREQUENCY RANGE

PREDISTORSION POUR UN CHEMIN DE TRANSMISSION NON LINEAIRE EN HAUTE FREQUENCE

(84) Benannte Vertragsstaaten:
**DE FR GB IT SE**

(30) Priorität: **19.06.1996 DE 19624447**
**02.08.1996 DE 19631388**

(43) Veröffentlichungstag der Anmeldung:
**23.12.1998 Patentblatt 1998/52**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **PERTHOLD, Rainer**
**D-91058 Erlangen (DE)**
• **GERHÄUSER, Heinz**
**D-91344 Waischenfeld (DE)**

(74) Vertreter: **Schoppe, Fritz, Dipl.-Ing.**
**Schoppe & Zimmermann,**
**Patentanwälte,**
**Postfach 71 08 67**
**81458 München (DE)**

(56) Entgegenhaltungen:
**EP-A- 0 387 948        EP-A- 0 608 697**

• **IEE PROCEEDINGS: COMMUNICATIONS, Bd. 143, Nr. 2, 1.April 1996, Seiten 78-86, XP000592638 GHADERI M ET AL: "FAST ADAPTIVE POLYNOMIAL I AND Q PREDISTORTER WITH GLOBAL OPTIMISATION"**
• **MICROWAVE JOURNAL, Bd. 27, Nr. 8, August 1984, DEDHAM US, Seiten 127-134, XP002038942 M. KUMAR ET AL: "GAAS DUAL-GATE FET LINEARIZER FOR TRAVELING-WAVE TUBE AMPLIFIERS"**

**Beschreibung**

Die vorliegende Erfindung bezieht sich auf Modulationsverfahren, die zu einer nichtkonstanten Hüllkurve eines hochfrequenten Trägersignals führen, und insbesondere auf die Vorverzerrung für eine nichtlineare Übertragungsstrecke im Hochfrequenzbereich.

Werden in einem beispielsweise drahtlosen Kommunikationssystem Modulationsverfahren eingesetzt, die zu einer nichtkonstanten Hüllkurve des hochfrequenten Trägersignals führen, müssen alle Signalverarbeitungskomponenten nach dem Modulator eine hinreichende Linearität aufweisen. Diese Forderung ist besonders bei Leistungsverstärkerstufen, die mit einem guten Wirkungsgrad arbeiten sollen, schwer zu erfüllen.

Bei der Verwendung von Puls-Ampliduden-Modulationsverfahren verschlechtert sich die spektrale Effizienz durch die Nichtlinearität der Verstärker. Der Grund dafür liegt in den nichtlinearen Amplitudenausgangscharakteristika eines Verstärkers, was zu einer AM/AM-Konversion führt, wobei ferner das Driften der Phase eines Ausgangssignals eines Verstärkers bezüglich der Phase eines Eingangssignals Intermodulationskomponenten erzeugt, was auch als AM/PM-Konversion bezeichnet wird.Die AM/AM- und die AM/PM-Konversion müssen jedoch durch geeignete Linearisierungsverfahren unterbunden werden. Wird dies nicht durchgeführt, verschlechtert sich die spektrale Effizienz des eingesetzten Modulationsverfahrens sowie der Signal/Rausch-Abstand. In digitalen Übertragungssystemen kann sich dadurch die Bitfehlerrate bei der Übertragung wesentlich erhöhen.

Insbesondere in Übertragungssystemen, die eine QPSK-Modulation verwenden (QPSK = Quatenary Phase Shift Keying = Vierphasenumtastung), wie es beispielsweise bei Mobiltelefonsystemen der Fall ist, ist es besonders wichtig, den nichtlinearen Bereich von Leistungsverstärkern auszunützen. Aufgrund der Tatsache, daß bei beispielsweise Mobiltelefonen die verfügbare Leistungsversorgung begrenzt ist, d.h. ein größerer Akku führt zu einer wesentlichen Gewichtszunahme und Verteuerung eines Mobiltelefons, muß der Endstufenverstärker mit möglichst hohem Wirkungsgrad arbeiten, was jedoch nicht in seinem linearen Verstärkungsbereich möglich ist. Leistungsverstärker mit hohem Wirkungsgrad werden daher bevorzugt in ihrem nichtlinearen Bereich in der Nähe der Sättigung betrieben, was zu nichtlinearen Verzerrungen mit den beschriebenen Problemen führt.

Modulationsverfahren, die neben der PAM-Modulation eine Linearisierung erfordern, sind grundsätzlich alle Mehrträgerverfahren, (z.B. COFDM beim digitalen Rundfunk) und alle Pulsamplitudenmodulations-Verfahren, zu denen neben der QPSK-Modulation auch die QAM-Modulation gehört. Weitere Einsatzmöglichkeiten für die Vorverzerrung einer nichtlinearen Übertragungsstrecke bestehen im Bereich der Basisstationen von Mobilfunksystemen, wenn mehrere Frequenzkanäle parallel auf eine Senderendstufe gegeben werden.

Es besteht also ein Bedarf nach einem geeigneten Linearisierungsverfahren basierend auf der Vorverzerrung. Dieses könnte in allen Fällen Anwendung finden, in denen allgemein eine nichtlineare Übertragungsstrecke linearisiert werden soll. Die Linearisierung einer nichtlinearen Übertragungsstrecke sollte ferner zulassen, daß sich der Frequenzbereich des Eingangssignals in die zu entzerrende nichtlineare Übertragungsstrecke von dem Frequenzbereich des Ausgangssignales aus der nichtlinearen Übertragungsstrecke heraus unterscheiden kann. Die Linearisierung darf daher nicht auf reine Verstärkerstufen beschränkt sein, sondern es müssen auch Frequenzumsetzungen innerhalb der nichtlinearen Übertragungsstrecke vorgenommen werden können.

In der Technik existieren bereits mehrere Verfahren zum Linearisieren von Hochfrequenzendstufen. Die bekanntesten Verfahren zum Linearisieren von Hochfrequenzendstufen lassen sich folgendermaßen einordnen.

Bei der digitalen Vorverzerrung eines zu übertragenden Signales werden die digital dargestellten Werte des Signals mit geeignet gewählten Koeffizienten multipliziert. Die Vorverzerrung erfolgt somit zusammen mit dem digitalen Erzeugen des Steuersignals des Modulators.

Ein weiteres bekanntes Verfahren ist die analoge Vorverzerrung. Sie bedient sich nichtlinearer Bauteile, wie z.B. Schottky-Dioden, um eine zu der Verstärkerverzerrungkennlinie komplementäre Entzerrungskennlinie zu synthetisieren.

Die "kartesische Schleife" ("auch Cartesian Loop" genannt) stellt eine analoge Gegenkopplung der Hochfrequenzendstufe dar, welche im Basisband durchgeführt wird.

Die Vorwärtskopplung (in der Technik auch "Feedforward" genannt) stellt im Sinne der Regelungstechnik eine Störgrößenaufschaltung dar, wobei zu dem Ausgangsignal der Endstufe eine entsprechende Korrekturspannung addiert wird, um die Verzerrung der Endstufe zu kompensieren.

In der WO 93/18581 ist eine "Cartesian Loop" beschrieben, deren Parameter entsprechend verschiedener Systemparameter, die den aktuellen Betriebszustand des Systems wiederspiegeln, eingestellt werden. Ein Funksendegerät weist dabei einen Leistungsverstärker, eine Linearisierungseinrichtung und eine Rückkopplungseinrichtung zum Rückkoppeln eines Signals von einem Ausgang des Leistungsverstärkers zu der Linearisierungseinrichtung auf, um die Linearität des Ausgangssignals sicherzustellen. Die Linearisierungseinrichtung arbeitet im Basisband, wobei die IQ-Signale von einer linearen Steuerung gesteuert werden, welche mit einer Direktzugriffstabelle verbunden ist, welche vorbestimmte Schleifenlinearisierungsparameter speichert. Nachdem die IQ-Signale durch die Linearisierungseinrichtung geeignet verarbeitet worden sind, werden diese verarbeiteten Signale mittels eines Aufwärtsmischers hochgemischt und durch den Leistungsverstärker verstärkt. Die Rückkopplungseinrichtung nimmt ein Ausgangssignal des Leistungsverstärkers, mischt es mittels eines Abwärtsmischers herunter, und speist das heruntergemischte Signal in die Linearisierungseinrichtung ein. Die Linearisierung erfolgt daher nicht im Hochfrequenzbereich, sondern im Basisbandbereich, da auf die IQ-Signale zugegriffen wird. Ferner verwirklicht die beschriebene Schaltung eine dauerhafte Gegenkopplung der HF-Endstufe im Sinne einer Cartesian Loop.

Die GB 2240893 A offenbart eine Schaltung zur Linearisierung der Amplitudenantwort und der Phasenantwort eines Verstärkers. Eine Hüllkurvendetektorschaltung erfaßt die Hüllkurve eines zu übertragenden Eingangssignales, wobei das Ausgangssignal der Hüllkurvendetektorschaltung in eine Steuerschaltung vom nichtlinearen Typ sowie in eine Phasenschiebersteuerschaltung eingegeben wird. Die Phasenschiebersteuerschaltung steuert einen Phasenschieber, der vor dem Leistungsverstärker angeordnet ist, um das Hochfrequenzsignal phasenmäßig vorzuverzerren. Die Steuerschaltung vom nichtlinearen Typ liefert ein Eingangssignal in einen spannungsvariablen Gleichspannungs-Gleichspannungswandler, welcher die Vorspannungsparameter, d.h. den Arbeitspunkt des Leistungsverstärkers geeignet einstellt, um die Verzerrung des nichtlinearen Verstärkers zu kompensieren. Der Amplitudenfehler der Verstärkers wird daher über dessen Arbeitspunkteinstellung kompensiert, was den Nachteil besitzt, daß die Arbeitspunktparameter des Verstärkers ständig geändert werden müssen, was eine Anpassung des Verstärkers an eine Last wesentlich erschweren kann. Üblicherweise erfordert nämlich ein geänderter Arbeitspunkt automatisch ein anderes (komplexes) Transformationsverhältnis des Ausgangswiderstandes.

Das US-Patent Nr. 5,023,937 stellt eine analoge Vorverzerrungsschaltung für einen im nichtlinearen Bereich betriebenen Leistungsverstärker dar. Diese Vorverzerrung arbeitet mittels einer Gegenkopplungsschleife, bei der im Gegensatz zur Cartesian Loop nicht die IQ-Komponenten des Ausgangssignals geregelt werden, sondern der Betrag und die Phase desselben. Ein Hüllkurvendetektor erfaßt die Amplitude des zu verstärkenden Signals, welche durchgehend rückkopplungsmäßig mit der Hüllkurve des Ausgangssignals des Leistungsverstärkers verglichen wird, wobei das Vergleichsergebnis an ein variables Dämpfungsglied angelegt ist, das das Eingangssignal vor dem Leistungsverstärker geeignet dämpft, um ein möglichst lineares Ausgangssignal zu erzeugen. Die Phasenvorverzerrung wird mittels einer Phasenregelschleife durchgeführt, die als Eingangssignal das zu verstärkende Signal erhält. Ein Teil des Ausgangssignals des Verstärkers wird mittels eines Mischers, eines Lokaloszillators und einer Phasenschieberschaltung ebenfalls in die Phasenregelschleife eingegeben, welche ein Lokaloszillatorsignal für einen vor dem Leistungsverstärker angeordneten Mischer liefert, um das zu verstärkende Signal phasenmäßig geeignet vorzuverzerren. Diese Schaltung arbeitet vollständig analog und basiert auf einer im wesentlichen durchgehenden Rückkopplung, falls die vorhandene Phasenregelschleife eingerastet ist.

Das US-Patent Nr. 4,465,980 stellt ebenfalls eine analoge Vorverzerrungsschaltung dar. Ein Detektor erfaßt die Hüllkurve eines zu verstärkenden Signals und legt dieses Signal an einen Feldeffekttransistor mit zwei Gate-Anschlüssen ("Dual Gate FET") an. An das andere Gate des Dual-Gate-FET wird das zu verstärkende Signal angelegt. Durch geeignetes Steuern des Arbeitspunktes dieses Dual-Gate-FET wird das HF-Eingangssignal geeignet vorverzerrt, um die nichtlineare Verstärkung eines Leistungsverstärkers, der über ein Anpassungsnetzwerk mit dem Drain-Anschluß des Dual-Gate-FET verbunden ist, zu kompensieren.

Die DE 3312030 A1 offenbart einen Verstärker mit Vorverzerrungskompensation, welcher Vorverzerrungskomponenten verwendet, die von einem dem Verstärkungsbauteil ähnlichen Leistungsverstärkungsbauteil erzeugt werden, um eine wirksame Linearisierung zur wesentlichen Reduzierung aller Intermodulations-Verzerrungsprodukte zu erreichen. Ferner kann eine zusätzliche Rückkopplungsschaltung vorgesehen werden, um eine weitere Verringerung von Nichtlinearitäten zu erreichen.

Die GB 8723874 offenbart eine Linearitätskorrekturschaltung, die in einem Zwischenfrequenzbereich arbeitet, um eine geeignete Vorverzerrung in eine Amplitudenhüllkurve einzuführen, um die Nichtlinearität der Leistungsverstärkerstufen zu kompensieren. Ein Array von parallelen Stromquellen, von denen jede als Reaktion auf eine Vorverzerrung über einem entsprechenden Amplitudenband einstellbar ist, speist einen Strom ein, der ausreichend ist, um eine geeignete Differenzspannung an dem Ausgang einzuführen. Bei dieser Schaltung findet offensichtlich keine Phasenvorverzerrung statt.

Die EP 0 658 975 A1 bezieht sich auf ein Basisbandvorverzerrungssystem für die adaptive Linearisierung von Leistungsverstärkern und auf einen Funksender, der das Vorverzerrungssystem verwendet. Dabei werden zwei Fehlertabellen, und zwar eine für die Amplitude und eine für die Phase, aktualisiert, wobei der Inhalt derselben zum Korrigieren der Basisbandabtastwerte verwendet wird. Der Inhalt der Tabellen wird erhalten, indem eine geeignet gewichtete Differenz zwischen Abtastwerten, die in das Vorverzerrungsgerät eingegeben werden, und einem demodulierten Rückkopplungswert akkumuliert wird. Eine Vorverzerrung wird also ähnlich zu der WO93/1851, wie vorher beschrieben wurde, nicht im Hochfrequenzbereich, sondern digital im Basisband durchgeführt, wobei ein Zugriff auf die digitale Signalaufbereitung im Basisband vorhanden sein muß.

Eine digitale Vorverzerrung, wie sie in der EP 0 658 975 A1 und in der W093/18581 beschrieben ist, bedingt eine Zugriffsmöglichkeit auf das Modulationssignal, bevor es von einer digitalen Darstellung in einen Analogspannungswert umgewandelt wird, um die erforderlichen digitalen Berechnungen zur Korrektur von Trägeramplitude und Trägerphase durchführen zu können. Dieser Zugriff ist in vielen Fällen nicht gegeben, da nur innerhalb des abgeschlossenen Systems der Leistungsendstufe linearisiert werden kann.

Bei der analogen Vorverzerrung des Hochfrequenzsignals ergibt sich das Problem, eine geeignete Kennlinie aus nichtlinearen Bauteilen synthetisieren zu müssen, welche Exemplarstreuungen, Temperaturdrift, Alterung usw. aufweisen. Bei Alterung der Bauteile kann sich die Nichtlinearität verstärken.

Die "Cartesian Loop", d.h. eine HF-Gegenkopplung, reagiert sehr empfindlich auf Parameterschwankungen. Durch die hohe Verstärkung besteht ferner eine erhebliche Schwingneigung der gesamten Anordnung bei nicht exakt ermittelten Parametern der Rückkopplung. Ebenfalls wird durch die Gegenkopplung das Rauschverhalten der Endstufe drastisch verschlechtert, da die Gegenkopplung ihrerseits unkorreliertes Rauschen in die Verstärkerstufe einführt.

Das "Feedforward"-Verfahren erfordert eine genaue Bestimmung der Signallaufzeiten der Endstufe. Die Linearitätsanforderungen an das Korrektursignal sind hoch, weshalb bei einer Schaltung, die eine Linearisierung gemäß dem Vorwärtskopplungsverfahren durchführt, hochwertige und teure Leistungsverstärker eingesetzt werden müssen.

Die EP 0 608 697 A1 offenbart ein Modulationsverfahren und eine Modulationsschaltung für Hochfrequenzsignale. Dabei werden die NF-Modulationssignale, die mittels einer komplexen IQ-Modulation einem HF-Träger aufmoduliert werden, im NF-Bereich derart vorverzerrt, daß Toleranzen der HF-Bauteile des Modulators, d. h. des 0°-90°-Hybrids und der Mischer, die zu Unsymmetrien zwischen dem I- und dem Q-Zweig führen, ausgeglichen werden. Die Vorverzerrung der NF-Modulationssignale stellt dabei sicher, daß z. B. bei einer Einseitenbandmodulation der Träger und das unerwünschte Seitenband ausreichend unterdrückt sind.

Die Fachveröffentlichung IEE Proceedings: Communications, Bd. 143, Nr. 2, 1. April 1996, Seiten 78 - 86, Ghaderi M. u. a., "Fast Adaptive Polynomial I and Q Predistorter with Global Optimisation", gegen die die unabhängigen Ansprüche abgegrenzt sund, offenbart eine Linearisiererstruktur für einen Hochfrequenzverstärker, wobei die Vorverzerrung auf der Zwischenfrequenz implementiert ist. Dazu wird die Hüllkurve eines Zwischenfrequenzsignals erfaßt und bei einer digitalen Implementation quantisiert. Ferner wird eine Nachschlagtabelle zur Implementation von Verstärkungsfunktionen angesprochen, einer analogen Implementation wird jedoch aus Einfachheitsgründen der Vorzug gegeben. Diese Verstärkungsfunktionen stellen die inversen Nichtlinearitäten des Hochfrequenz-Leistungsverstärkers dar, dessen Nichtlinearitäten mittels Polynomfunktionen angenähert werden. Ein IQ-Modulator bewirkt eine Vorverzerrung des NF-Signals, wobei die IQ-Modulationssignale von den Verstärkungsfunktionen und der Hüllkurve des NF-Signals abhängen.

Ausgehend von diesem Stand der Technik liegt der vorliegenden Erfindung die Aufgabe zugrunde, eine Schaltung zum Vorverzerren eines über eine nichtlineare Übertragungsstrecke zu übertragenden Signals und ein Verfahren zum Vorverzerren eines derartigen Signals zu schaffen, um auf flexible und zuverlässige Art und Weise eine optimale Kompensation der durch die nichtlineare Übertragungsstrecke eingeführten Verzerrung zu erreichen.

Diese Aufgabe wird durch eine Schaltung gemäß Anspruch 1 sowie durch ein Verfahren gemäß Anspruch 14 gelöst.

Bei der Vorverzerrung besteht das Kernproblem darin, eine Realisierung einer nichtlinearen Kennlinie zu finden, die mit hinreichender Genauigkeit einstellbar ist und durch lineare Bauteile realisiert werden kann. Da es, wie bereits angemerkt wurde, schwierig ist, eine nichtlineare Kennlinie beispielsweise durch Schottky-Dioden nachzubilden, verwendet die vorliegende Erfindung eine Tabelleneinrichtung, die Vorverzerrungskoeffizienten enthält, die von der Amplitude des Eingangssignals sowie von den Eigenschaften der nichtlinearen Übertragungsstrecke, die beispielsweise ein Verstärker oder eine Verstärker-Mischer-Anordnung sein kann, abhängen. Die Vorverzerrung erfolgt durch Multiplikation des Eingangssignals mit den komplexen Vorverzerrungskoeffizienten. Diese Vorverzerrungskoeffizienten sind komplexe Zahlen, die einen Realteil, d. h. eine I-Komponente, und einen Imaginärteil, d.h. eine Q-Komponente, aufweisen.

Im äquivalenten Tiefpaßbereich wird daher ein komplexes Ausgangssignal $\underline{y}(t)$ aus einem komplexen Eingangssignal $\underline{v}(t)$ gemäß folgender Gleichung erzeugt:

$$\underline{y}(t) = \underline{v}(t)\underline{A}(|v(t)|)$$

In dieser Gleichung stellt $\underline{A}(|v(t)|)$, die komplexe Verstärkung dar, die erforderlich ist, um die AM/AM- und die AM/PM-Konversion der nichtlinearen Übertragungsstrecke zu korrigieren. Diese nichtlineare Funktion hängt im wesentlichen von der Amplitude des Eingangssignals v(t) ab. Die Aufgabe besteht nun darin, diese komplexe Funktion $\underline{A}$ geeignet zu linearisieren, um das Eingangssignal v(t) geeignet vorverzerren zu können. Die Lösung dieser Aufgabe besteht in einer abschnittsweisen Linearisierung der komplexen Verstärkung, wobei in einer bestimmten Staffelung für jede Eingangssignalamplitude ein komplexer Vorverzerrungskoeffizient gewonnen wird. Die nichtlineare Verstärkung $\underline{A}$ wird also abschnittsweise linearisiert, wobei die Auflösung, d.h. die Anzahl der Linearisierungen in einem bestimmten Amplitudenbereich, von den Anforderungen sowie von der zur Verfügung stehenden Speicherkapazität der Tabelleneinrichtung abhängt. Die abschnittsweise Linearisierung der komplexen Verstärkung A, d.h. die Vielzahl von komplexen Vorverzerrungskoeffizienten, erlaubt also eine praktische Implementierung des Verfahrens, welche es gestattet, die Vorverzerrung direkt im HF-Bereich durchzuführen.

Die Vorverzerrung mit abschnittsweise konstanten Vorverzerrungskoeffizienten ist besonders dort vorteilhaft, wo kein Zugriff auf die digitale Darstellung des Signals (im Basisband) möglich ist. Ferner ist das erfindungsgemäße Vorverzerrungsverfahren gegenüber Parameterschwankungen unempfindlich, da alle Parameterschwankungen durch geeignetes Einstellen der Vorverzerrungskoeffizienten kompensiert werden können.

Das Rauschverhalten der nichtlinearen Übertragungsstrecke wird nicht wesentlich verschlechtert, da im Gegensatz zur HF-Gegenkopplung kein unkorreliertes Rauschen in den Signalweg eingeführt wird. Ein weiterer Vorteil der vorliegenden Erfindung gegenüber Vorverzerrungsverfahren, die eine Rückkopplung verwenden, besteht darin, daß die nichtlineare Übertragungsstrecke gegen Rückkopplungsschwingungen unempfindlich ist, da kein direkter Rückkopplungspfad vorhanden ist.

Wesentlich für das erfindungsgemäße Vorverzerrungsverfahren ist eine genaue und effiziente Bestimmung der in der Tabelleneinrichtung vorhandenen Vorverzerrungskoeffizienten. Diese müssen jedoch nicht in Echtzeit durchgehend bestimmt werden, sondern es ist ausreichend, dieselben beispielsweise vor Inbetriebnahme der Schaltung oder zu bestimmten Kalibrierzeitpunkten digital zu berechnen.

Die Verzögerungszeit der erfindungsgemäßen Vorverzerrung ist von vorneherein festgelegt und nicht von irgendwelchen Parametern abhängig, da die Vorverzerrung durch einen externen Takt synchronisiert ist. Eine Kompensation der Verzögerungszeit ist daher auf einfache Art und Weise zuverlässig möglich.

Bevorzugte Ausführungsbeispiele der vorliegenden Erfindung werden nachfolgend bezugnehmend auf die beiliegenden Zeichnungen detaillierter erläutert. Es zeigen:

Fig. 1    ein Blockdiagramm einer Schaltung zum Vorverzerren gemäß einem ersten Ausführungsbeispiel der vorliegenden Erfindung; und

Fig. 2    ein Blockdiagramm einer Schaltung zum Vorverzerren gemäß einem zweiten Ausführungsbeispiel der vorliegenden Erfindung.

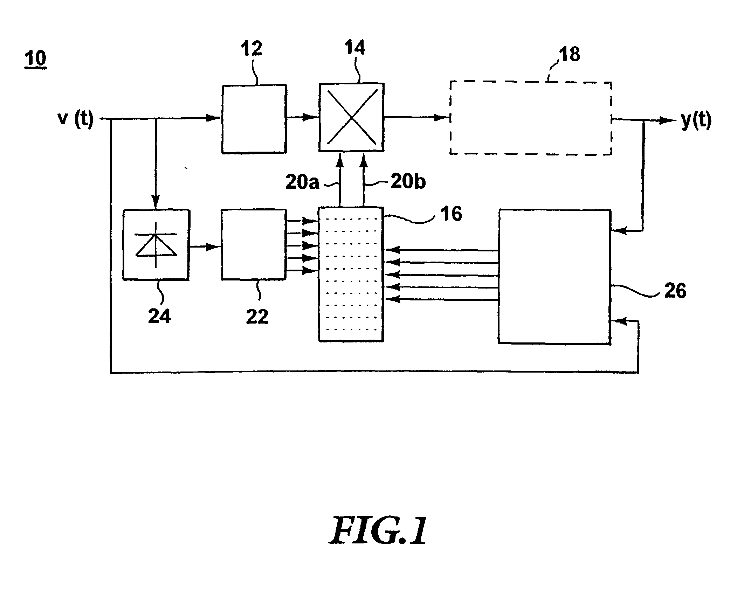

Wie es in Fig. 1 gezeigt ist, gelangt ein Eingangssignal in eine Vorverzerrungsschaltung 10 über eine Verzögerungseinrichtung 12 in eine Bewertungseinrichtung 14 zum komplexen Bewerten des Eingangssignals v(t) mit komplexen Vorverzerrungskoeffizienten, welche in einer Tabelleneinrichtung 16 gespeichert sind. Die Bewertungseinrichtung 14 kann beispielsweise eine Einrichtung zum komplexen Multiplizieren eines Eingangssignals, d.h. ein IQ-Modulator, sein.

Die Bewertungseinrichtung 14 erhält von der Tabelleneinrichtung 16 von der Amplitude des Eingangssignals v(t) und von der Übertragungsfunktion einer nichtlinearen Übertragungsstrecke 18 abhängige komplexe Vorverzerrungskoeffizienten. Der Realteil eines komplexen Vorverzerrungskoeffizienten wird über einen I-Kanal 20a in die Bewertungseinrichtung 14 eingegeben, während der Imaginärteil eines einer bestimmten Eingangsamplitude entsprechenden Vorverzerrungskoeffizienten über einen Q-Kanal in die komplexe Bewertungseinrichtung 14 eingegeben wird.

Die Tabelleneinrichtung 16 wird von einer Quantisierungseinrichtung 22 adressiert, welche quantisierte Hüllkurvenwerte bildet, und zwar in Abhängigkeit der Hüllkurve des Eingangssignals v(t), die von einer Hüllkurvenerfassungseinrichtung 24 erfaßt wird. Ein geeigneter Anteil des Eingangssignals v(t), der zur Erfassung der Hüllkurve nötig ist, kann auf für Fachleute bekannte Art und Weise, wie z.B. durch einen Richtkoppler, aus dem Hauptsignalweg, der in Fig. 1 der direkten Verbindung von v(t) zu y(t) entspricht, entnommen werden.

Wie bereits erwähnt wurde, werden bei der vorliegenden Erfindung die Vorverzerrungskoeffizienten, die in der Tabelleneinrichtung 16 gespeichert sind und durch die Quantisierungseinrichtung 22 geeignet adressiert werden, außerhalb des Betriebs der Schaltung, z.B. bei der Schaltungsherstellung oder bei der Inbetriebnahme, berechnet und abgespeichert. Um zu bestimmten Zeitpunkten während des Betriebs der Schaltung 10 eine Feinabstimmung der Vorverzerrungskoeffizienten durchführen zu können, kann optional eine Vergleichseinrichtung 26 vorgesehen sein, die das Eingangssignal v(t) und das Ausgangssignal y(t) vergleicht, um festzustellen, ob zwischen beiden ein linearer Zusammenhang, wie z.B. eine einfache Verstärkung, besteht. Sollte kein linearer Zusammenhang vorhanden sein, deutet dies darauf hin, daß sich Umgebungsbedingungen verändert haben, weswegen die Vorverzerrungskoeffizienten nicht mehr optimal eingestellt sind. In einem Neukalibrationsschritt greift nun die Vergleichseinrichtung 26 auf die Tabelleneinrichtung 16 zu, um die Vorverzerrungskoeffizienten entsprechend den neuen Umgebungsbedingungen geeignet zu modifizieren.

Im Betrieb wird ein bestimmter Bruchteil des Eingangssignals v(t) durch die Hüllkurvenerfassungseinrichtung 24, die beispielsweise ein Diodengleichrichter sein kann, möglichst linear gleichgerichtet, um den Betrag der Amplitude des Eingangssignals v(t) zu gewinnen. Diese Hüllkurve des Eingangssignals wird der Quantisierungseinrichtung 22 zum Bilden von quantisierten Hüllkurvenwerten aufgrund der erfaßten Hüllkurve zugeführt. Mittels dieser quantisierten Hüllkurvenwerte wird die Tabelleneinrichtung 16 adressiert, die die komplexen Vorverzerrungskoeffizienten beispielsweise in kartesischer Darstellung enthält. Der einer speziellen Amplitude der Hüllkurve entsprechende komplexe Vorverzerrungskoeffizient wird als Reaktion auf eine Adressierung der Tabelleneinrichtung über den I-Kanal und über den Q-Kanal nach Real-bzw. Imaginärteil der Bewertungseinrichtung 14 zugeführt, die als komplexer IQ-Modulator ausgeführt ist und die dem Eingangssignal v (t) eine zum Erhalten eines linear verstärkten Ausgangssignals y(t) der nichtlinearen Übertragungsstrecke 18 erforderliche Vorverzerrung aufmoduliert. Die Linearität des Gleichrichters ist nicht zwingend erforderlich, solange sein Verhalten bekannt ist. Unzulänglichkeiten können bei der Festlegung der komplexen Koeffizienten in der Tabelle entsprechend kompensiert werden. Etwaige geringe Nichtlinearitäten des Multiplizierers können durch eine adaptive Entzerrung, die die Vergleichseinrichtung 26 verwendet, automatisch ausgeregelt werden. Die Koeffizienten werden entsprechend modifiziert.

Der signalweg über die Hüllkurvenerfassungseinrichtung 24, die Quantisierungseinrichtung 22 und die Tabelleneinrichtung 16 sowie das Einstellen der komplexen Vorverzerrungskoeffizienten weist eine geringe Verzögerungszeit in der Größenordnung von < 100 ns auf. Sofern erforderlich kann diese verzögerungszeit durch die der Bewertungseinrichtung 14 vorgeschaltete Verzögerungseinrichtung 12 ausgeglichen werden.

Bei der Entzerrung der nichtlinearen Übertragungsstrecke 18 kann das Verhalten derselben durch ihre Übertragungsfunktion, d.h. den Quotient aus dem verzerrten Ausgangssignal und dem Eingangssignal, nach Betrag und Phase charakterisiert werden. Diese Übertragungsfunktion kann im HF-Bereich erhalten werden. Eine vorherige Frequenzumsetzung in das Basisband oder auf eine Zwischenfrequenz ist jedoch ebenfalls optional möglich. Aus der Übertragungsfunktion der nichtlinearen Übertragungsstrecke 18 können dann Schätzwerte für die AM/AM- und die AM/PM-Kennlinie der nichtlinearen Übertragungsstrecke 18 berechnet werden. Die entsprechenden Vorverzerrungskoeffizienten werden dann anschließend aus den Meßwerten ermittelt und entsprechend in der Tabelleneinrichtung 16 gespeichert.

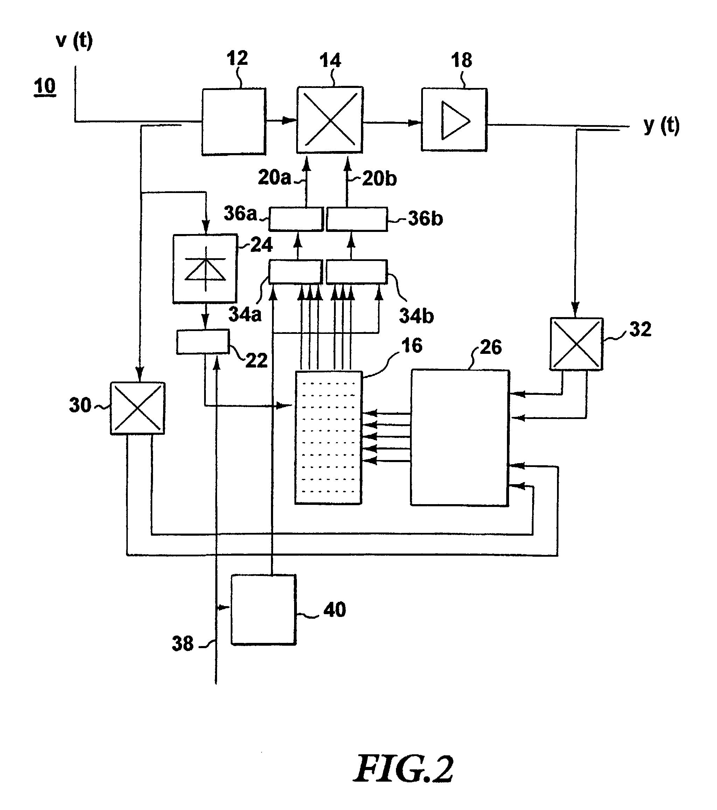

Fig. 2 zeigt ein zweites Ausführungsbeispiel der erfindungsgemäßen Vorverzerrungsschaltung 10. In Fig. 1 und Fig. 2 gleiche Komponenten sind durch gleiche Bezugszeichen gekennzeichnet. Im Zusammenhang mit Fig. 2 werden lediglich die neu hinzugekommenen Schaltungskomponenten näher erläutert, wobei bezüglich der in Fig. 2 und Fig. 1 vorhandenen Komponenten auf deren Beschreibung im Zusammenhang mit Fig. 1 verwiesen wird.

Im Unterschied zu Fig. 1 enthält die Vorverzerrungsschaltung 10 gemäß einem zweiten Ausführungsbeispiel der vorliegenden Erfindung einen Eingangsabwärtsmischer 30 sowie einen Ausgangsabwärtsmischer 32. Beide Abwärtsmischer 30, 32 liefern jeweils zwei Werte, die beispielsweise Real- und Imaginärteil des Eingangs- bzw. des Ausgangssignals sein können, in die Vergleichseinrichtung 26, die beim zweiten Ausführungsbeispiel der vorliegenden Erfindung ein digitaler Signalprozessor sein kann. Ferner weist das zweite Ausführungsbeispiel zwischen der Tabelleneinrichtung 16 und der Bewertungseinrichtung 14 für den I-Zweig sowie für den Q-Zweig jeweils eine Kombination aus einem Digital/Analog-Wandler 34a, 34b sowie einem nachgeschalteten Tiefpaß 36a, 36b auf. Die Tiefpaßfilterung des I- und des Q-Zweiges dienen zur wirksamen Unterdrückung von Nebenaussendungen in Nachbarfrequenzkanäle. Die Quantisierungseinrichtung 22, die beispielsweise ein Analog/Digital-Wandler sein kann, und die Digital/Analog-Wandler 34a, 34b werden durch einen gemeinsamen Takt 38 getaktet, wobei jedoch der Takt für die Digital/Analog-Wandler 34a, 34b durch eine Taktverzögerungseinrichtung 40 im Vergleich zu dem Takt der Quantisierungseinrichtung 22 geeignet verzögert ist, um die Verzögerung der Tabelleneinrichtung 16 zu berücksichtigen. Die Verzögerung der Taktverzögerungseinrichtung 40 sowie die Verzögerung der Tabelleneinrichtung 16 werden so gewählt, daß die Durchlaufverzögerungen der Quantisierungseinrichtung 22 und der Tabelleneinrichtung 16 kleiner als die Zeitverzögerung der Taktverzögerungseinrichtung 40 sind. Die Bestimmung der AM/AM- und der AM/PM-Kennlinie der nichtlinearen Übertragungsstrecke, die beim zweiten Ausführungsbeispiel als Endstufe 18 ausgeführt ist, erfolgt über das durch den Eingangsabwärtsmischer 30 demodulierte Eingangssignal v(t) sowie über das durch den Ausgangsabwärtsmischer 32 demodulierte Ausgangssignal y(t).

Das zweite Ausführungsbeispiel der vorliegenden Erfindung kann beispielsweise die Endstufe in einem Hauptsender oder Füllsender für den digitalen Rundfunk linearisieren, um die Aussendung in den Nachbarkanälen unterhalb der geforderten Grenzwerte zu halten und gleichzeitig eine geringe Verlustleistung der Endstufe 18 zu erreichen.

In Abweichung der beschriebenen Ausführungsbeispiele ist es ferner möglich, die Realisierung der Vorverzerrung durch A/D-Umsetzung in der Quantisierungseinrichtung 22, durch die Tabelle in der Tabelleneinrichtung 16 sowie durch die D/A-Umsetzung in den beiden Digital/Analog-Wandlern 34a, 34b durch eine einzige Einheit zu realisieren, die in Form einer integrierten Schaltung vorhanden ist. Bei dieser Realisierung kann, wie es beim ersten Ausführungsbeispiel der Fall ist, auf die Digital/Analog-Umsetzung 34a, 34b verzichtet werden, wobei es die Schaltungsintegration ermöglicht, die Vorverzerrung lediglich durch eine Quantisierung und eine nachfolgende Zuweisung eines analogen Ausgangssignals zu realisieren, welches noch gering vom analogen Eingangssignal abhängt, was die benötigte Auflösung für die Vorverzerrungskoeffizienten reduzieren kann. Die integrierte Schaltung weist hierbei programmierbare Stromquellen auf, deren Werte adaptiv nachgeführt werden. Vorteile dieser Realisierung sind eine höhere Verarbeitungsgeschwindigkeit sowie ein geringerer Stromverbrauch der Vorverzerrungsschaltung 10.

Ferner ist es bei dem in Fig. 2 gezeigten Ausführungsbeispiel optional möglich, die Hüllkurvenerfassungseinrichtung 24 vor der Auslieferung der Schaltung oder nach bestimmten Kalibrationsintervallen zu kalibrieren. Das Eingangssignal in die Hüllkurvenerfassungseinrichtung 24 steht über den Eingangsabwärtsmischer 30 zur Verfügung, während das Ausgangssignal der Hüllkurvenerfassungseinrichtung als quantisierte Adressierung der Tabelleneinrichtung 16 vorliegt. Dies ermöglicht es, bei Bedarf die quantisierten Ausgangswerte der Hüllkurvenerfassungseinrichtung 24 ebenfalls in den digitalen Signalprozessor 26 einzulesen und außerhalb des Betriebs der Vorverzerrungsschaltung 10 die Kennlinie der Hüllkurvenerfassungseinrichtung durch Vergleich der beiden genannten Signale zu bestimmen. Dies kann für eine Korrektur der in der Tabelleneinrichtung 16 gespeicherten Vorverzerrungskoeffizienten auf vorteilhafte Weise ausgenutzt werden.

Bei den meisten nichtlinearen Übertragungsstrecken, welche beispielsweise Leistungsverstärker sein können, bleibt der eingeführte Phasenfehler innerhalb eines Quadranten, d.h. zwischen 0° und 90°. Dann wird es ausreichend sein, statt des komplexen IQ-Modulators, der ein Vierquadrantenmultiplizierer ist, eine Anordnung bestehend aus einem π/2-Hybrid, je einem Dämpfungsglied für den I- bzw. für den Q-Kanal und einem nachfolgenden 0°-Kombinierer zu verwenden. Diese Bewertungseinrichtung hat gegenüber dem komplexen (passiven) IQ-Multiplizierer den Vorteil, daß sie eine höherer Linearität aufweisen kann.

**Patentansprüche**

1. Schaltung (10) zum Vorverzerren eines über eine nichtlineare Übertragungsstrecke (18) zu übertragenden Signals (v), mit folgenden Merkmalen:

einer Hüllkurvenerfassungseinrichtung (24) zum Erfassen einer Hüllkurve des Signals (v);

einer Quantisierungseinrichtung (22) zum Bilden von quantisierten Hüllkurvenwerten aufgrund der erfaßten Hüllkurve;

einer Tabelleneinrichtung (16) zum Speichern von komplexen Vorverzerrungskoeffizienten; und

einer von der nichtlinearen Übertragungsstrecke (18) getrennten Vorverzerrungseinrichtung (14) zum komplexen Vorverzerren des Signals (v) mit den komplexen Vorverzerrungskoeffizienten, derart, daß die durch die nichtlineare Übertragungsstrecke (18) eingeführte Verzerrung nach Betrag und Phase im wesentlichen kompensiert ist,

dadurch gekennzeichnet,

daß die in der Tabelleneinrichtung (16) gespeicherten komplexen Vorverzerrungskoeffizienten von einer abschnittsweisen Linearisierung der vorab erfaßten nichtlinearen Übertragungsstrecke (18) abhängen, wobei einem Linearisierungsabschnitt ein komplexer Vorverzerrungskoeffizient zugeordnet ist, und

daß der komplexe Vorverzerrungskoeffizient, der von der Tabelleneinrichtung (16) der Vorverzerrungseinrichtung (14) zugeführt wird, der ist, der dem Linearisierungsabschnitt zugeordnet ist, in dem ein quantisierter Hüllkurvenwert liegt, der der Tabelleneinrichtung (16) zugeführt wird.

2. Schaltung (10) gemäß Anspruch 1, bei der die nichtlineare Übertragungsstrecke (18) ein Leistungsverstärker ist.

3. Schaltung (10) gemäß Anspruch 1 oder 2, bei der die Quantisierungseinrichtung (22) ein Analog/Digital-Wandler ist.

4. Schaltung gemäß einem beliebigen der vorhergehenden Ansprüche, bei der die Hüllkurvenerfassungseinrichtung (24) eine Diodengleichrichteranordnung ist.

5. Schaltung (10) gemäß einem beliebigen der vorhergehenden Ansprüche, bei der die Vorverzerrungseinrichtung (14) ein IQ-Modulator ist.

6. Schaltung gemäß einem beliebigen der Ansprüche 1 bis 4, bei der die Vorverzerrungseinrichtung (14) eine Anordnung aus einem π/2-Hybrid, aus zwei zueinander parallel geschalteten Dämpfungsgliedern und aus einem 0°-Kombinierer aufweist.

7. Schaltung gemäß einem beliebigen der vorhergehenden Ansprüche,

bei der die Quantisierungseinrichtung (22) und die Tabelleneinrichtung (16) in einer einzigen integrierten Schaltung realisiert sind, derart, daß in der integrierten Schaltung vorhandene programmierbare Quellen als Reaktion auf die quantisierten Hüllkurvenwerte gesteuert werden, um der Vorverzerrungseinrichtung (14) analoge IQ-Signale zu liefern.

8. Schaltung gemäß einem beliebigen der Ansprüche 1 bis 6,

bei der zwischen der Tabelleneinrichtung (16) und der Vorverzerrungseinrichtung (14) Digital/Analog-Wandler (34a, 34b) für sowohl das I- als auch das Q-Signal sowie Tiefpaßfilter (36a, 36b) angeordnet sind.

9. Schaltung (10) gemäß einem beliebigen der vorhergehenden Ansprüche,

bei der signalflußmäßig vor der Vorverzerrungseinrichtung (14) eine Verzögerungseinrichtung (12) angeordnet ist, um die durch die Strecke von der Quantisierungseinrichtung (22) zu der Vorverzerrungseinrichtung (14) eingeführte zeitliche Verzögerung zu kompensieren.

10. Schaltung (10) gemäß einem beliebigen der vorhergehenden Ansprüche,

bei der eine Vergleichseinrichtung (26) das über die nichtlineare Übertragungsstrecke (18) zu übertragende Signal (v) mit einem Ausgangssignal (y) der nichtlinearen Übertragungsstrecke (18) vergleicht und dementsprechend die Vorverzerrungskoeffizienten der Tabelleneinrichtung zu vorbestimmten Zeitpunkten einstellt.

11. Schaltung gemäß Anspruch 10,

bei der ein Eingangsabwärtsmischer (30) das über die nichtlineare Übertragungsstrecke (18) zu übertragende Signal (v) und ein Ausgangsabwärtsmischer (32) das Ausgangssignal (y) der nichtlinearen Übertragungsstrecke (18) in das Basisband umsetzen; und

bei der die Vergleichseinrichtung (26) ein digitaler Signalprozessor ist.

12. Schaltung gemäß einem beliebigen der Ansprüche 8 bis 11,

bei der die Quantisierungseinrichtung (22) und die Digital/Analog-Wandler (34a, 34b) für den I- und Q-Kanal (20a, 20b) durch den gleichen Takt (38) getaktet werden, wobei jedoch der Takt für die Digital/Analog-Wandler für den I- und den Q-Kanal (20a, 20b) gegenüber dem Takt für die Quantisierungseinrichtung (22) durch eine Taktverzögerungseinrichtung (40) verschoben sind, um die durch die Tabelleneinrichtung (16) eingeführte Verzögerung zu kompensieren.

13. Schaltung gemäß Anspruch 11 oder 12,

bei der die Hüllkurvenerfassungseinrichtung (24) kalibriert wird, indem die quantisierten Hüllkurvenwerte und die Hüllkurve selbst in die Vergleichseinrichtung (26) eingegeben werden, wodurch die Kennlinie der Hüllkurvenerfassungseinrichtung (24) bestimmt werden kann, um die Vorverzerrungskoeffizienten in der Tabelleneinrichtung (16) zu vorbestimmten Zeitpunkten entsprechend zu korrigieren.

14. Verfahren zum Vorverzerren eines über eine nichtlineare Übertragungsstrecke (18) zu übertragenden Signals (v), mit folgenden Schritten:

Erfassen einer Hüllkurve des Signals;

Bilden von quantisierten Hüllkurvenwerten aufgrund der erfaßten Hüllkurve;

tabellarisches Speichern von komplexen Vorverzerrungskoeffizienten; und

komplexes Vorverzerren des über die nichtlineare Übertragungsstrecke (18) zu übertragenden Signals (v) mit den komplexen Vorverzerrungskoeffizienten, derart, daß die durch die nichtlineare Übertragungsstrecke (18) eingeführte Verzerrung nach Betrag und Phase im wesentlichen kompensiert ist,

dadurch gekennzeichnet,

daß die tabellarisch gespeicherten komplexen Vorverzerrungskoeffizienten von einer abschnittsweisen Linearisierung der vorab erfaßten nichtlinearen Übertragungsstrecke (18) abhängen, wobei einem Linearisierungsabschnitt ein komplexer Vorverzerrungskoeffizient zugeordnet ist, und

daß der komplexe Vorverzerrungskoeffizient, der im Schritt des komplexen Vorverzerrens verwendet wird, der ist, der dem Linearisierungsabschnitt zugeordnet ist, in dem ein quantisierter Hüllkurvenwert liegt.

**Claims**

1. A circuit (10) for predistorting a signal (v) to be transmitted via a non-linear channel (18), comprising:

   an envelope detector (24) for detecting an envelope of the signal (v);

   a quantization means (22) for forming quantized envelope values on the basis of the detected envelope;

   a table means (16) for storing complex predistortion coefficients; and

   a predistortion means (14) separated from said non-linear channel (18) and used for the complex predistortion of the signal (v) with the complex predistortion coefficients in such a way that the distortion introduced by the non-linear channel (18) is substantially compensated according to amount and phase,

   characterized in

   that the complex predistortion coefficients stored in the table means (16) depend on a sectionwise linearization of the previously detected non-linear channel (18), a linearization section having associated therewith a complex predistortion coefficient, and

   that the complex predistortion coefficient supplied by said table means (16) to said predistortion means (14) is the complex predistortion coefficient that is associated with the linearization section in which a quantized envelope value lies which is supplied to the table means (16).

2. A circuit (10) according to claim 1,

   wherein the non-linear channel (18) is a power amplifier.

3. A circuit (10) according to claim 1 or 2,

   wherein the quantization means (22) is an analog-to-digital converter.

4. A circuit according to any of the preceding claims,

   wherein the envelope detector (24) is a diode rectifier arrangement.

5. A circuit (10) according to any of the preceding claims,

   wherein the predistortion means (14) is an IQ modulator.

6. A circuit according to any of the claims 1 to 4,

   wherein the predistortion means (14) comprises an arrangement consisting of a $\pi/2$ hybrid, two attenuators connected in parallel, and an 0° combiner.

7. A circuit according to any of the preceding claims,

   wherein the quantization means (22) and the table means (16) are realized in a single integrated circuit in such a way that programmable sources provided in said integrated circuit are controlled in response to the quantized envelope values so as to supply analog IQ signals to the predistortion means (14).

8. A circuit according to any of the claims 1 to 6,

   wherein digital-to-analog converters (34a, 34b) for the I as well as for the Q signal and lowpass filters (36a, 36b) are arranged between the table means (16) and the predistortion means (14).

9. A circuit according to any of the preceding claims,

   wherein the predistortion means (14) is preceded by a delay means (12) as far as signal flow is concerned so as to compensate for the time delay introduced by the path from the quantization means (22) to the predistortion means (14).

10. A circuit (10) according to any of the preceding claims,

    wherein a comparison means (26) compares the signal (v) to be transmitted via the non-linear channel (18) with an output signal (y) of the non-linear channel (18) and adjusts the predistortion coefficients of the table means at predetermined times accordingly.

11. A circuit according to claim 10,

    wherein an input down-conversion mixer (30) converts the signal (v) to be transmitted via the non-linear channel (18) into the baseband and an output down-conversion mixer (32) converts the output signal (y) of the non-linear channel (18) into the baseband; and

wherein the comparison means (26) is a digital signal processor.

**12.** A circuit according to any of the claims 8 to 11,

wherein the quantization means (22) and the digital-to-analog converters (34a, 34b) for the I and Q channels (20a, 20b) are clocked by the same clock (38), the clock for the digital-to-analog converter for the I and Q channels (20a, 20b) being, however, shifted relative to the clock for the quantization means (22) by a clock delay means (40) so as to compensate for the delay introduced by the table means (16).

**13.** A circuit according to claim 11 or 12,

wherein the envelope detector (24) is calibrated by inputting the quantized enevelope values and the envelope itself into the comparison means (26), whereby the characteristic of the envelope detector (24) can be determined so as to correct the predistortion coefficients in the table means (16) at predetermined times accordingly.

**14.** A method of predistorting a signal (v) to be transmitted via a non-linear channel (18), said method comprising the following steps:

detecting an envelope of the signal;

forming quantized envelope values on the basis of the detected envelope;

storing complex predistortion coefficients in tabular form; and

carrying out a complex predistortion of the signal (v) to be transmitted via the non-linear channel (18) with the complex predistortion coefficients in such a way that the distortion introduced by the non-linear channel (18) is substantially compensated according to amount and phase,

characterized in

that the complex predistortion coefficients stored in tabular form depend on a sectionwise linearization of the previously detected non-linear channel (18), a linearization section having associated therewith a complex predistortion coefficient, and

that the complex predistortion coefficient used in the complex-predistortion step is the complex predistortion coefficient that is associated with the linearization section in which a quantized envelope value lies.

**Revendications**

**1.** Circuit (10) de préaccentuation d'un signal (v) à transmettre via un chemin de transmission (18) non linéaire, ayant les caractéristiques suivantes :

- un dispositif (24) de saisie de courbes enveloppantes pour saisir une courbe enveloppante du signal (v) ;
- un dispositif de quantification (22) pour constituer des valeurs de courbes enveloppantes quantifiées sur la base de la courbe enveloppante saisie ;
- un dispositif (16) de constitution de tables pour mémoriser des coefficients de préaccentuation complexe ; et
- un dispositif de préaccentuation (14) séparé du chemin de transmission (18) non linéaire servant à la préaccentuation complexe du signal (v) avec les coefficients de préaccentuation complexe, de façon telle que la préaccentuation induite par le chemin de transmission (18) non linéaire est compensée essentiellement suivant l'amplitude et la phase,

caractérisé

- en ce que les coefficients de préaccentuation complexe, mémorisés dans le dispositif (16) de constitution de tables, dépendent d'une linéarisation segmentée du chemin de transmission (18) non linéaire préalablement saisi, où un coefficient de préaccentuation complexe est associé à un segment de linéarisation, et
- en ce que le coefficient de préaccentuation complexe, qui est acheminé par le dispositif (16) de constitution de tables du dispositif de préaccentuation (14), est le coefficient qui est associé au segment de linéarisation dans lequel se trouve une valeur de courbe enveloppante quantifiée qui est acheminée jusqu'au dispositif (16) de constitution de tables.

**2.** Circuit (10) selon la revendication 1, dans lequel le chemin de transmission (18) non linéaire est un amplificateur de puissance.

**3.** Circuit (10) selon la revendication 1 ou 2, dans lequel le dispositif de quantification (22) est un convertisseur analogique/numérique.

**4.** Circuit selon l'une quelconque des revendications précédentes, dans lequel le dispositif (24) de saisie de courbes enveloppantes est un redresseur à diodes.

5. Circuit (10) selon l'une quelconque des revendications précédentes, dans lequel le dispositif de préaccentuation (14) est un modulateur IQ.

6. Circuit selon l'une quelconque des revendications 1 à 4, dans lequel le dispositif de préaccentuation (14) comprend un dispositif se composant d'un hybride de type $\pi/2$, de deux éléments atténuateurs montés en parallèle l'un par rapport à l'autre et d'un combinateur à 0°.

7. Circuit selon l'une quelconque des revendications précédentes, dans lequel le dispositif de quantification (22) et le dispositif (16) de constitution de tables sont réalisés dans un circuit intégré unique, de façon telle que des sources programmables, présentes dans le circuit intégré, sont commandées en réaction aux valeurs de courbes enveloppantes quantifiées, pour fournir des signaux IQ analogiques au dispositif de préaccentuation (14).

8. Circuit selon l'une quelconque des revendications 1 à 6, dans lequel des convertisseurs numériques/ analogiques (34a, 34b) sont disposés entre le dispositif (16) de constitution de tables et le dispositif de préaccentuation (14), servant aussi bien pour le signal I que pour le signal Q, ainsi que des filtres passe-bas (36a, 36b).

9. Circuit (10) selon l'une quelconque des revendications précédentes, dans lequel un dispositif à retard (12) est prévu en amont du dispositif de préaccentuation (14), dans la direction d'émission des signaux (14), pour compenser le retard dû au temps de parcours depuis le dispositif de quantification (22) jusqu'au dispositif de préaccentuation (14).

10. Circuit (10) selon l'une quelconque des revendications précédentes, dans lequel un dispositif comparateur (26) compare le signal (v) à transmettre via le chemin de transmission (18) non linéaire, à un signal de sortie (y) du chemin de transmission (18) non linéaire et qui, en conséquence, règle les coefficients de préaccentuation du dispositif de constitution de tables, à des moments prédéterminés.

11. Circuit selon la revendication 10, dans lequel un mélangeur abaisseur (30), côté entrée, convertit, dans la bande de base, le signal (v) à transmettre via le chemin de transmission (18) non linéaire et dans lequel un mélangeur abaisseur (32), côté sortie, convertit, dans la bande de base, le signal de sortie (y) du chemin de transmission (18) non linéaire, et où le dispositif comparateur (26) est un processeur de signaux numériques.

12. Circuit selon l'une quelconque des revendications 8 à 11, dans lequel le dispositif de quantification (22) et les convertisseurs numériques/analogiques (34a, 34b) pour le canal I (20a) et le canal Q (20b) sont rythmés par la même impulsion d'horloge (38), où l'impulsion d'horloge pour les convertisseurs numériques/analogiques pour le canal I (20a) et le canal Q (20b) est cependant décalée par rapport à l'impulsion d'horloge pour le dispositif de quantification (22), par un dispositif à retard d'impulsion d'horloge (40), pour compenser le retard dû au dispositif (16) de constitution de tables.

13. Circuit selon la revendication 11 ou 12, dans lequel le dispositif (24) de saisie de courbes enveloppantes est calibré, tandis que les valeurs de courbes enveloppantes quantifiées et la courbe enveloppante elle-même sont introduites dans le dispositif comparateur (26), grâce à quoi la courbe du dispositif (24) de saisie de courbes enveloppantes peut être déterminée, pour corriger en conséquence, à des moments prédéterminés, les coefficients de préaccentuation du dispositif (16) de constitution de tables.

14. Procédé de préaccentuation d'un signal (v) à transmettre via un chemin de transmission (18) non linéaire, comprenant les étapes suivantes consistant :

   - à saisir une courbe enveloppante du signal ;
   - à constituer des valeurs de courbes enveloppantes quantifiées sur la base de la courbe enveloppante saisie ;
   - à mémoriser dans des tables des coefficients de préaccentuation complexe ; et
   - à réaliser la préaccentuation complexe du signal (v) à transmettre via le chemin de transmission (18) non linéaire, avec les coefficients de préaccentuation complexe, de façon telle que la préaccentuation induite par le chemin de transmission (18) non linéaire est compensée essentiellement suivant l'amplitude et la phase,

   caractérisé

   - en ce que les coefficients de préaccentuation complexe mémorisés dans des tables dépendent d'une linéarisation segmentée du chemin de transmission (18) non linéaire préalablement saisi, où un coefficient de préaccentuation complexe est associé à un segment de linéarisation, et
   - en ce que le coefficient de préaccentuation complexe, qui est utilisé au cours de la préaccentuation complexe, est le coefficient qui est associé au segment de linéarisation dans lequel se trouve une valeur de courbe envelop-

pante quantifiée.

**FIG.1**

FIG.2